# EUROPÄISCHE PATENTANMELDUNG

(11) **EP 1 508 903 A2**
(43) Veröffentlichungstag der Anmeldung: **23.02.2005**
(21) Anmeldenummer: 04016187.9
(22) Anmeldetag: 09.07.2004
(51) Int. Cl.: H01B 1/12

(54) **Dotierte organische Halbleitermaterialien sowie Verfahren zu deren Herstellung**

(30) Priorität: 18.08.2003 DE 10338406
(71) Anmelder: Novaled GmbH, 01069 Dresden (DE)
(72) Erfinder: Werner, Ansgar, Dipl.-Phys., 01277 Dresden (DE); Pfeiffer, Martin, Dr., 01139 Dresden (DE); Fenghong, Li, 01069 Dresden (DE)
(74) Vertreter: Bittner, Thomas L., Dr.

(57) **Zusammenfassung**

Die Erfindung betrifft ein Verfahren zur Herstellung von dotierten organischen Halbleitermaterialien mit erhöhter Ladungsträgerdichte und effektiver Ladungsträgerbeweglichkeit durch Dotierung mit einem Dotanden (1), wobei nach dem Einmischen des Dotanden (1) in das organische Halbleitermaterial Wasserstoff, Kohlenoxid, Stickstoff oder Hydroxyradikale abgespalten wird und zumindest ein Elektron auf das Halbleitermaterial oder von dem Halbleitermaterial übertragen wird. Das Verfahren zeichnet sich dadurch aus, dass als Dotand (1) eine ungeladene organische Verbindung verwendet wird.

Ferner betrifft die Erfindung dotierte organische Halbleitermaterialien, erhältlich durch eines der Verfahren. Die Halbleitermaterialien zeichnen sich dadurch aus, dass in der dotierten Schicht Kationen (2) zumindest einer organische Verbindung enthalten ist, wobei die ungeladene Form der organischen Verbindung (1) an der Luft nicht stabil ist.

## Beschreibung

Die Erfindung betrifft dotierte organische Halbleitermaterialien mit erhöhter Ladungsträgerdichte und effektiver Ladungsträgerbeweglichkeit sowie ein Verfahren zu deren Herstellung durch Dotierung mit einem Dotanden, wobei nach dem Einmischen des Dotanden in das organische Halbleitermaterial Wasserstoff, Kohlenoxid, Stickstoff oder Hydroxyradikale abgespalten wird und zumindest ein Elektron auf das Halbleitermaterial oder von dem Halbleitermaterial übertragen wird.

Seit der Demonstration von organischen Leuchtdioden und Solarzellen 1989 [C.W. Tang et al., *Appl. Phys.* Lett., 1987, 913] sind aus organischen Dünnschichten aufgebaute Bauelemente Gegenstand intensiver Forschung. Derartige Schichten besitzen vorteilhafte Eigenschaften für die genannten Anwendungen, wie z.B. effiziente Elektrolumineszenz für organische Leuchtdioden, hohe Absorptionskoeffizienten im Bereich des sichtbaren Lichtes für organische Solarzellen, preisgünstige Herstellung der Materialien und Fertigung der Bauelemente für einfachste elektronische Schaltungen, u.a. Kommerzielle Bedeutung hat bereits der Einsatz organischer Leuchtdioden für Displayanwendungen.

Die Leistungsmerkmale (opto-)elektronischer mehrschichtiger Bauelemente werden unter anderem von der Fähigkeit der Schichten zum Transport der Ladungsträger bestimmt. Im Falle von Leuchtdioden hängen die ohmschen Verluste in den Ladungstransportschichten beim Betrieb mit der Leitfähigkeit zusammen, was einerseits direkten Einfluss auf die benötigte Betriebsspannung hat, andererseits aber auch die thermische Belastung des Bauelements bestimmt. Weiterhin kommt es in Abhängigkeit von der Ladungsträgerkonzentration der organischen Schichten zu einer Bandverbiegung in der Nähe eines Metallkontakts, die die Injektion von Ladungsträgern erleichtert und damit den Kontaktwiderstand verringern kann. Ähnliche Überlegungen führen auch für organische Solarzellen zu dem Schluss, dass deren Effizienz auch durch die Transporteigenschaften für Ladungsträger bestimmt ist.

Durch Dotierung von Löchertransportschichten mit einem geeigneten Akzeptormaterial (p-Dotierung) bzw. von Elektronentransportschichten mit einem Donatormaterial (n-Dotierung) kann die Ladungsträgerdichte in organischen Festkörpern (und damit die Leitfähigkeit) beträchtlich erhöht werden. Darüber hinaus sind in Analogie zur Erfahrung mit anorganischen Halbleitern Anwendungen zu erwarten, die gerade auf Verwendung von p- und n-dotierten Schichten in einem Bauelement beruhen und anders nicht denkbar wären. In US 5,093,698 ist die Verwendung von dotierten Ladungsträgertransportschichten (p-Dotierung der Löchertransportschicht durch Beimischung von akzeptorartigen Molekülen, n-Dotierung der Elektronentransportschicht durch Beimischung von donatorartigen Molekülen) in organischen Leuchtdioden beschrieben.

Gegenüber Dotierungsverfahren mit anorganischen Materialien, welche zum einen Diffusionsprobleme des verwendeten Dotierungsmaterials in Form von relativ kleinen Molekülen bzw. Atomen und zum anderen unerwünschte unvorhersehbare chemische Reaktionen zwischen Matrix und Dotierungsmaterial mit sich bringen, hat sich die Verwendung organischer Moleküle als Dotierungsmaterial als vorteilhaft erwiesen. Im allgemeinen weisen organische Dotanden eine höhere Stabilität der Bauelemente auf, und die Diffusion spielt eine untergeordnete Rolle, so dass die definierte Herstellung scharfer Übergänge von p-dotierten zu n-dotierten Bereichen vereinfacht wird. Bei einer Dotierung mit organischen Molekülen kommt es ausschließlich zu einem Ladungstransfer zwischen Matrix und Dotiermaterial, zwischen diesen wird jedoch keine chemische Bindung ausgebildet. Ferner liegt die Dotierkonzentration zum Erhalt einer hohen Leitfähigkeit der dotierten Schicht im Fall von organischen Dotanden vorteilhaft etwa drei bis vier Größeneinheiten unter der von anorganischen Dotanden.

Der Einsatz von organischen Dotanden ist insofern nachteilig, als die gewünschten Dotiermaterialien, welche sich durch extreme Elektronenaffinitäten bzw. Reduktionspotentiale für die p-Dotierung oder entsprechende Ionisationspotentiale bzw. Oxidationspotentiale für die n-Dotierung auszeichnen, eine geringe chemische Stabilität aufweisen und schwer zugänglich sind.

A. G. Werner et al., *Appl. Phys. Lett., 2003, 4495-7* zeigt die Verwendung von Pyronin B als Dotierungsmaterial für organische Halbleitermaterialien. Dazu wird Pyronin B Clorid sublimiert, wobei im wesentlichen Chlorwasserstoff und eine reduzierte, protonierte Form des Pyronin B, nämlich die Leukobase des Pyronin B, entsteht. Die Leukobase wird als eine stabile Vorläufersubstanz verwendet, die durch Verdampfen im Vakuum in Gegenwart eines Matrixmaterials mit geringer Akzeptorstärke wieder zu einem Kation oxidiert wird.

Ein Nachteil dieses Verfahrens ergibt sich aus der Reaktion zur Bildung der Leukoform des kationischen Farbstoffs. Bei dieser Reaktion tritt Polymerisierung des Pyronin B auf, die in einer nur beschränkten Sublimierbarkeit von Pyronin B Chlorid resultiert.

Ferner ist aus H. Yokoi et al., *Chemestry Letters,* 1999, 241-2 eine photochemische Dotierung von Tetrafluorotetracyanoquinodimethan (TCNQ) durch photoinduzierten Elektronentransfer und C-C-Spaltung des Radikalkations bekannt, wobei TCNQ mit Dimeren des Dotanden, beispielsweise Di(p-methoxyphenylamin)methyl, durch Verreiben in einem Mörser vermischt wird. Durch Beleuchtung erfolgt eine Oxidierung des Dimers und ein Elektronentransfer auf TNCQ. Bei der Oxidierung wird die C-C-Bindung aufgespalten und ein Monomerkation und ein Monomerradikal gebildet. Durch Elektronentransfer auf TCNQ wird das Monomerrakial zum Kation oxidiert.

Das Verfahren ist insoweit nachteilig, als eine Anwendung im Vakuum nicht möglich ist und daher nicht in Kombination mit den üblichen organischen Halleitermaterialien, wie beispielsweise Fulleren C₆₀, verwendbar ist. Prinzipiell besteht ein direkter reziproker Zusammenhang zwischen der Stabilität des Dimers und der des Kationmonomers, so dass ein umso stabileres Kationmonomer als ungeladenes Dimer nur bedingt stabil ist.

Der Erfindung liegt daher die Aufgabe zu Grunde, die Herstellung von organischen dotierten Halbleitermaterialen hinsichtlich der Ausbeute und Reinheit zu verbessern.

Erfindungsgemäß wird die Aufgabe dadurch gelöst, dass als Dotand eine neutrale organische Verbindung verwendet wird. Durch die Verwendung der hydrierten Form einer organischen Verbindung werden die Polymerisierungsprobleme und die Einwirkung von Nebenprodukten, wie beispielsweise Chlorwasserstoff, im Gegensatz zur direkten Verwendung eines Salze der organischen Verbindung vermieden.

Hierbei kann die hydrierte Form einer organischen Verbindung im gereinigten Zustand eingesetzt und direkt in das organische Halbleitermaterial eingemischt werden. Die hydrierten Formen von organischen Verbindungen sind neutrale, nicht-ionische Moleküle und zeigen deshalb eine im wesentlichen vollständige Sublimation, so dass der Wirkung der durch die Sublimation des gebildeten kationischen Farbstoffs gleich der Dotierwirkung der so verdampften hydrierten Form einer organischen Verbindung ist.

Zweckmäßigerweise wird der Dotand in der hydrierten Form der organischen Verbindung durch Sublimation eines Salzes der organischen Verbindung hergestellt. Die Herstellung der hydrierten Form der organischen Verbindung ist somit ein vorgestellter eigenständiger Schritt in Abwesenheit des organischen Halbleitermaterials. Ferner können weitere Aufreinigungsprozesse zur Verbesserung der Ausbeute und Reinheit der hydrierten Form der organischen Verbindung durchgeführt werden.

Bei der Dotierung ist vorgesehen, dass die ungeladene organische Verbindung durch Abspaltung von Wasserstoff, Kohlenoxid, Stickstoff oder Hydroxyradikalen in das Kation oder Radikal der organischen Verbindung umgewandelt wird. Somit kann durch Übertragung eines Elektrons von dem Radikal auf das Halbleitermaterial eine n-Dotierung bzw. durch Aufnahme des Kations aus dem Halbleitermaterial eine p-Dotierung erfolgen.

In einer Ausführungsform der Erfindung wird Wasserstoff, Kohlenoxid, Stickstoff oder Hydroxyradikale von einem Cyclopentadien, Cycloheptatrien oder einem sechsgliedrigen Heterozyklus abgespalten. Eine Elektronenabgabe (n-Dotierung) oder Aufnahme (p-Dotierung) wird durch die Ausbildung eines 6pi-aromatischen Systems begünstigt.

Alternativ oder zusätzlich kann das Cyclopentadien, Cycloheptatrien oder der sechsgliedrige Heterozyklus Bestandteil eines Systems kondensierter Ringe sein, so dass auch die Ausbildung eines 8pi-, 10pi-, 12pi- oder eines anderen (2n)pi-Systems den Elektronentransfer begünstigen.

Vorteilhafterweise ist die ungeladene organische Verbindung die Carbinolbase oder die Leukobase eines kationischen Farbstoffes. Die Verwendung solcher Moleküle weist eine hohe Quanteneffizienz der Lichtausbeute von organischen Leuchtdioden auf. Beispielsweise haben kationische Farbstoffe, so wie z.B. Rhodamin B, oft eine hohe Luminiszenzquantenausbeute, die den späteren Einsatz als Lumineszenzfarbstoffe in organischen LED ermöglichen.

Alternativ können auch Xanthen-, Acridin-, Diphenylamin-, Triphenylamin-, Azin-, Oxazin-, Thiazin- oder Thioxanthenfarbstoffderivate als Farbstoff verwendet werden. Die Auswahl der zur Dotierung geeigneten Substanzen ist allerdings nicht auf kationische Farbstoffe beschränkt. Beispielsweise sind auch solche Verbindungen geeignet, die durch Abspaltung einer anderen Gruppe als Hydrid in das Kation umgewandelt werden können.

Weitere vorteilhafte Ausgestaltungen ergeben sich aus den Unteransprüchen.

Ferner werden zur Lösung der Aufgabe durch das erfindungsgemäße Verfahren dotierte organische Halbleitermaterialien mit erhöhter Ladungsträgerdichte und effektiver Ladungsträgerbeweglichkeit bereitgestellt, wobei in der dotierten Schicht Kationen zumindest einer organischen Verbindung, deren ungeladene Form an der Luft nicht stabil ist, enthalten sind.

Weitere vorteilhafte Ausgestaltungen ergeben sich aus den Unteransprüchen.

Die Erfindung wird nachstehend anhand eines in der Zeichnung dargestellten Ausführungsbeispiels erläutert werden.

Es zeigt:

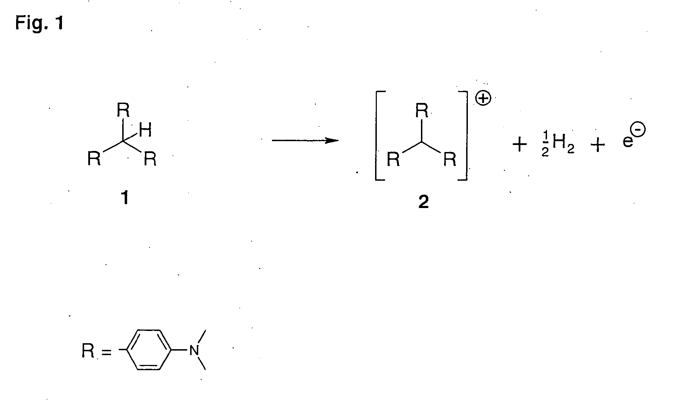

- Figur 1: die erfindungsgemäße Reaktion von Leuko-Kristallviolett in das Kristallviolett-Kation durch Oxidation.

In einem Ausführungsbeispiel des erfindungsgemäßen Verfahrens zur Herstellung von dotierten organischen Halbleitern wird Kristallviolett als kationischer Farbstoff verwendet.

Der als Chloridsalz vorliegende und daher stabile Farbstoff wird zunächst in einem ersten Schritt sublimiert. Bei diesem Schritt wird Chlorwasserstoff freigesetzt. Man erhält die ungeladene reduzierte Form des Kristallviolett als dessen Leukobase 1 in geringer Ausbeute.

Die Leukobase 1 ist eine Vorläufersubstanz, aus welcher in einem zweiten Schritt der Donor 2 gewonnen wird. Bei Abwesenheit von UV-Strahlung ist das Leuko-Kristallviolett 1 an der Luft stabil. Das Leuko-Kristallviolett 2 weist ein Oxidationspotential von 0,7 V gegen SCE auf. Allgemein sind Materialien mit Oxidationspotentialen größer als 0,3 V gegen SCE kinetisch stabil, d.h. in der Luft inert. Die Inertheit des Leuko-Kristallviolett 1 in der Luft wirkt sich direkt vorteilhaft auf die Einfachheit der Handhabung des Vorläufersubstanz des Donors aus. So kann die Leukobase direkt in den Dotierungsprozess eingesetzt werden.

Dazu wird die reine Leukobase 1 in ein organisches Halbleitermaterial mit geeigneter Akzeptorstärke, nämlich Fulleren C₆₀, eingemischt. Die gewählte Dotierkonzentration richtet sich nach der gewünschten Leitfähigkeit. Typische Dotierkonzentrationen liegen im Bereich von 1:5000 bis 1:10, sie können aber 1:10 auch überschreiten.

Anschließend wird in einem zweiten Schritt die Leukobase 1 wieder zum Kation oxidiert, wodurch die Dotierwirkung erzeugt wird (Figur 1) . Das Leuko-Kristallviolett 1 reagiert also in dem zweiten Schritt zu dem Donor 2. Bei dieser Oxidierung reagiert die Leukobase 1 zu dem Kristallviolett-Kation, überträgt dabei ein Elektron auf das Halbleitermaterial Fulleren und spaltet Wasserstoff ab.

Das Kristallviolett-Kation weist ein Reduktionspotential von - 0,1 V gegen NHE auf und ist somit ein entschieden besserer Donor 2 als sämtliche bislang bekannte luftstabile organische Donoren. Daher sind allgemein kationische Farbstoffe zur Dotierung von Matrixmaterialien mit Reduktionspotentialen kleiner als 0 V gegen SCE, wie Fulleren C₆₀, besonders gut geeignet.

### Bezugszeichenliste

- 1: neutrale organische Verbindung (Dotand)
- 2: Kation der organischen Verbindung

## Patentansprüche

1. Verfahren zur Herstellung von dotierten organischen Halbleitermaterialien mit erhöhter Ladungsträgerdichte und effektiver Ladungsträgerbeweglichkeit durch Dotierung mit einem Dotanden (1), wobei nach dem Einmischen des Dotanden (1) in das organische Halbleitermaterial Wasserstoff, Kohlenoxid, Stickstoff oder Hydroxyradikale abgespalten wird und zumindest ein Elektron auf das Halbleitermaterial oder von dem Halbleitermaterial übertragen wird, **dadurch gekennzeichnet, dass** als Dotand (1) eine ungeladene organische Verbindung verwendet wird.

2. Verfahren nach Anspruch 1, **dadurch gekennzeichnet, dass** der Dotand (1) durch Sublimation eines Salzes der organischen Verbindung hergestellt wird.

3. Verfahren nach einem der Ansprüche 1 oder 2, **dadurch gekennzeichnet, dass** die ungeladene organische Verbindung (1) durch Abspaltung von Wasserstoff, Kohlenoxid, Stickstoff oder Hydroxyradikalen in das Kation oder Radikal der organischen Verbindung (2) umgewandelt wird.

4. Verfahren nach einem der Ansprüche 1 bis 3, **dadurch gekennzeichnet, dass** Wasserstoff, Kohlenoxid, Stickstoff oder Hydroxyradikalen von einem Cyclopentadien, Cycloheptatrien oder einem sechsgliedrigen Heterozyklus unter Ausbildung eines 6pi-aromatischen Systems abgespalten wird.

5. Verfahren nach Anspruch 4, **dadurch gekennzeichnet, dass** Cyclopentadien, Cycloheptatrien oder der sechsgliedrige Heterozyklus Bestandteil eines Systems kondensierter Ringe ist.

6. Verfahren nach einem der Ansprüche 1 bis 5, **dadurch gekennzeichnet, dass** die ungeladene organische Verbindung (1) die Carbinolbase oder die Leukobase eines kationischen Farbstoffes ist.

7. Verfahren nach einem der Ansprüche 1 bis 6, **dadurch gekennzeichnet, dass** als Farbstoff ein Xanthen-, Acridin-, Diphenylamin-, Triphenylamin-, Azin-, Oxazin-, Thiazin- oder Thioxanthenfarbstoffderivat verwendet wird.

8. Verfahren nach einem der Ansprüche 1 bis 7, **dadurch gekennzeichnet, dass** die ungeladene organische Verbindung (1) vor oder nach dem Einmischen in das organische Halbleitermaterial beleuchtet oder mit einem Elektronenstrahl angeregt wird.

9. Verfahren nach Anspruch 8, **dadurch gekennzeichnet, dass** das zur Beleuchtung verwendete Spektrum der Strahlung den Absorptionsbereich der neutralen Verbindung und/oder des zu dotierenden Halbleitermaterials zumindest teilweise überdeckt.

10. Verfahren nach einem der Ansprüche 1 bis 9, **dadurch gekennzeichnet, dass** zwischen dem Dotanden (1) und dem organischen Halbleitermaterial ohne Bildung einer chemischen Bindung zumindest eine Ladung transferiert wird.

11. Verfahren nach einem der Ansprüche 1 bis 10, **dadurch gekennzeichnet, dass** das organische Halbleitermaterial durch Mischverdampfung oder aufeinander folgende Verdampfung mit einem kationischen Farbstoff oder dessen Leukobase oder Carbinolbase dotiert wird, und dass die aus dem kationischen Farbstoff entstandene Verbindung durch Bestrahlung mit einem Elektronenstrahl oder Beleuchtung im Absorptionsbereich des organischen Halbleitermaterials und/oder der entstandenen Verbindung wieder in das Kation (2) umgewandelt wird.

12. Verfahren nach einem der Ansprüche 1 bis 11, **dadurch gekennzeichnet, dass** eine inhomogen dotierte Schicht erzeugt wird, wobei das organische Halbleitermaterial und der Dotand derartig aufeinander abgestimmte Redoxpotentiale aufweisen, dass die Verbindung in der Matrix bei Dunkelheit inert ist.

13. Dotierte organische Halbleitermaterialien mit erhöhter Ladungsträgerdichte und effektiver Ladungsträgerbeweglichkeit, **dadurch gekennzeichnet, dass** in der dotierten Schicht Kationen (2) zumindest einer organischen Verbindung, deren ungeladene Form an der Luft nicht stabil ist, enthalten ist.

14. Halbleitermaterialen nach Anspruch 13, **dadurch gekennzeichnet, dass** die organische Verbindung ein Farbstoff ist.

15. Halbleitermaterialen nach Anspruch 14, **dadurch gekennzeichnet, dass** der Farbstoff ein Xanthen-, Acridin-, Diphenylamin-, Triphenylamin-, Azin-, Oxazin-, Thiazin- oder Thioxanthenfarbstoff ist.

16. Halbleitermaterialen nach einem der Ansprüche 13 bis 15, **dadurch gekennzeichnet, dass** die ungeladene organische Verbindung (1) die Carbinolbase oder die Leukobase eines kationischen Farbstoffes ist.

17. Halbleitermaterialen nach einem der Ansprüche 13 bis 16, **dadurch gekennzeichnet, dass** Wasserstoff, Kohlenoxid, Stickstoff oder Hydroxyradikalen von einem Cyclopentadien, Cycloheptatrien oder einem sechsgliedrigen Heterozyklus abgespaltet ist.

18. Halbleitermaterialen nach Anspruch 17, **dadurch gekennzeichnet, dass** Cyclopentadien, Cycloheptatrien oder der sechsgliedrige Heterozyklus Bestandteil eines Systems kondensierter Ringe ist.
